# EUROPEAN PATENT SPECIFICATION

(11) **EP 2 869 332 B1**
(45) Date of publication and mention of the grant of the patent: **15.03.2017**
(21) Application number: 13810224.9
(22) Date of filing: 14.06.2013
(51) Int. Cl.: H01L 23/544, H01L 21/02, G03F 9/00, H01G 4/12, H01G 4/33, H01L 49/02, H01L 21/311

(54) **METHOD FOR MANUFACTURING THIN FILM LAMINATED ELEMENT**
VERFAHREN ZUR HERSTELLUNG EINES MIT EINEM DÜNNFILM LAMINIERTEN ELEMENTS
PROCÉDÉ PERMETTANT DE FABRIQUER UN ÉLÉMENT STRATIFIÉ À FILM MINCE

(30) Priority: 27.06.2012 JP 2012144453
(43) Date of publication of application: 06.05.2015
(73) Proprietor: Murata Manufacturing Co., Ltd., Nagaokakyo-shi, Kyoto 617-8555 (JP)
(72) Inventor: NOMURA, Masanobu, Nagaokakyo-shi Kyoto 617-8555 (JP); TAKESHIMA, Yutaka, Nagaokakyo-shi Kyoto 617-8555 (JP)
(74) Representative: Zimmermann, Tankred Klaus
(86) International application number: PCT/JP2013/066463
(87) International publication number: WO 2014/002794

(56) References cited:
- JP-A- S 594 198
- JP-A- H07 202 425
- JP-A- 2010 021 478
- US-A1- 2006 223 270

## Description

### Technical Field

The present invention relates to a method for producing a thin-film multilayer device that functions as a thin-film capacitor or the like.

### Background Art

An example of a known method for producing a thin-film multilayer device is a downward progress method disclosed in Prior Document 1 (Japanese Unexamined Patent Application Publication No. 2010-21478).

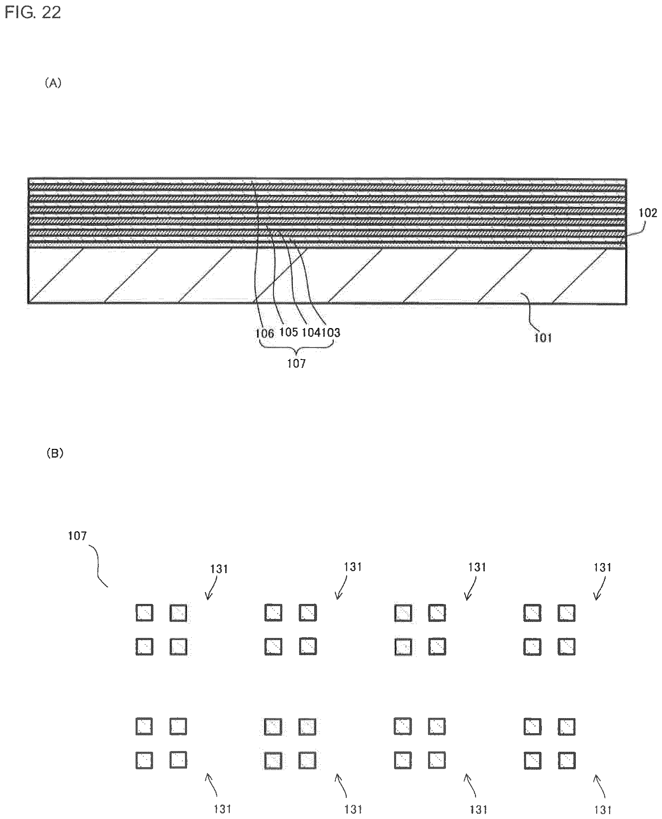

The downward progress method disclosed in Prior Document 1 begins with, as illustrated in Fig. 22 (A), forming a thin-film multilayer body 107 having multiple thin films 103, 104, 105, and 106 that function as components such as capacitor electrodes. Then photolithographic etching is repeated multiple times to perform processing on predetermined ones of the thin films 103, 104, 105, and 106 of the thin-film multilayer body 107 sequentially from the surface.

The downward progress method disclosed in Prior Document 1 includes forming multiple alignment marks 131 on the uppermost layer of the thin-film multilayer body 107 through photolithographic etching beforehand as illustrated in Fig. 22 (B) so that the thin-film multilayer body 107 is etched with high positional accuracy. These multiple alignment marks 131 are used to position a photomask in any of the repeated rounds of etching.

In each round of etching, any unnecessary alignment mark 131, which is not to be used in that round of etching, has to be covered with a photosensitive resist for protection against damage associated with etching. This means that a photosensitive resist is repeatedly applied to and detached from the alignment marks 131 that are used in later rounds of repeated etching.

### Citation List

### Patent Documents

Patent Document 1: Japanese Unexamined Patent Application Publication No. 2010-21478

### Summary of Invention

### Technical Problem

This known production method, however, often causes damage to the alignment marks 131 because in this method a photosensitive resist is applied to and detached from the same alignment marks 131 many times. The use of damaged alignment marks 131 causes a large misalignment between the correct position and the recognized one, leading to reduced accuracy in the processing of the thin-film multilayer body 107.

An object of the present invention is therefore to provide a method for producing a thin-film multilayer device, the method allowing the user to position a photomask for etching using a less-damaged alignment mark.

### Solution to Problem

To achieve this object, a method according to the present invention for producing a thin-film multilayer device include a first process having a step of forming a thin-film multilayer body having a plurality of thin films, a second process having a step of applying a photosensitive resist to the thin-film multilayer body, a step of exposing the resist through a photomask and developing the exposed resist, a step of etching the thin-film multilayer body coated with the developed photosensitive resist to form a device section and an alignment mark on the thin-film multilayer body, and a step of removing the photosensitive resist from the etched thin-film multilayer body, and a third process having a step of applying a photosensitive resist to the thin-film multilayer body, a step of placing a photomask having an alignment pattern in position on the photosensitive resist by aligning the alignment pattern with the alignment mark formed in a previous process, a step of exposing the photosensitive resist through the photomask and developing the exposed photosensitive resist, a step of etching the thin-film multilayer body coated with the developed photosensitive resist to form a device section and an alignment mark on the thin-film multilayer body, and a step of removing the photosensitive resist from the etched thin-film multilayer body.

### Advantageous Effects of Invention

According to a method according to the present invention for producing a thin-film multilayer device, reduced damage to alignment marks and a reduced misalignment between the correct position and the recognized one lead to enhanced accuracy in the processing of a thin-film multilayer body.

Furthermore, the approach of forming a thin-film multilayer body while forming alignment marks one by one allows the tolerance setting for the misalignments of the alignment marks to be smaller. Known devices whose functionality depends on the size of the area where the incorporated conductors, such as capacitors, overlap require the conductors have a large size in the initial design so that the functionality does not fall below the tolerance even with the occurrence of a misalignment, and this has on occasion caused the devices to be large in size. A production method according to the present invention allows the user to obtain the desired functionality without increasing the size and, furthermore, allows the user to reduce the size of a device without compromising its functionality.

### Brief Description of Drawings

[Fig. 1] Fig. 1 is a cross-sectional view that illustrates a process used in a method according to an embodiment of the invention for producing a thin-film multilayer device 100.
[Fig. 2] Fig. 2, a continuation of Fig. 1, is a cross-sectional view that illustrates a process used in a method according to an embodiment of the invention for producing a thin-film multilayer device 100.
[Fig. 3] Fig. 3, a continuation of Fig. 2, is a cross-sectional view that illustrates a process used in a method according to an embodiment of the invention for producing a thin-film multilayer device 100.
[Fig. 4] Fig. 4, a continuation of Fig. 3, illustrates a process used in a method according to an embodiment of the invention for producing a thin-film multilayer device 100. Fig. 4 (A) is a cross-sectional view taken along line A-A, and Fig. 4 (B) is a plan view with some details omitted.
[Fig. 5] Fig. 5, a continuation of Fig. 4, illustrates a process used in a method according to an embodiment of the invention for producing a thin-film multilayer device 100. Fig. 5 (A) is a cross-sectional view taken along line A-A, and Fig. 5 (B) is a plan view with some details omitted.
[Fig. 6] Fig. 6, a continuation of Fig. 5, illustrates a process used in a method according to an embodiment of the invention for producing a thin-film multilayer device 100. Fig. 6 (A) is a cross-sectional view taken along line A-A, and Fig. 6 (B) is a plan view with some details omitted.
[Fig. 7] Fig. 7, a continuation of Fig. 6, illustrates a process used in a method according to an embodiment of the invention for producing a thin-film multilayer device 100. Fig. 7 (A) is a cross-sectional view taken along line A-A, and Fig. 7 (B) is a plan view with some details omitted.
[Fig. 8] Fig. 8, a continuation of Fig. 7, illustrates a process used in a method according to an embodiment of the invention for producing a thin-film multilayer device 100. Fig. 8 (A) is a cross-sectional view taken along line A-A, and Fig. 8 (B) is a plan view with some details omitted.
[Fig. 9] Fig. 9, a continuation of Fig. 8, illustrates a process used in a method according to an embodiment of the invention for producing a thin-film multilayer device 100. Fig. 9 (A) is a cross-sectional view taken along line A-A, and Fig. 9 (B) is a plan view with some details omitted.
[Fig. 10] Fig. 10, a continuation of Fig. 9, illustrates a process used in a method according to an embodiment of the invention for producing a thin-film multilayer device 100. Fig. 10 (A) is a cross-sectional view taken along line A-A, and Fig. 10 (B) is a plan view with some details omitted.
[Fig. 11] Fig. 11, a continuation of Fig. 10, illustrates a process used in a method according to an embodiment of the invention for producing a thin-film multilayer device 100. Fig. 11 (A) is a cross-sectional view taken along line A-A, and Fig. 11 (B) is a plan view with some details omitted.
[Fig. 12] Fig. 12, a continuation of Fig. 11, illustrates a process used in a method according to an embodiment of the invention for producing a thin-film multilayer device 100. Fig. 12 (A) is a cross-sectional view taken along line A-A, and Fig. 12 (B) is a plan view with some details omitted.
[Fig. 13] Fig. 13, a continuation of Fig. 12, illustrates a process used in a method according to an embodiment of the invention for producing a thin-film multilayer device 100. Fig. 13 (A) is a cross-sectional view taken along line A-A, and Fig. 13 (B) is a plan view with some details omitted.
[Fig. 14] Fig. 14, a continuation of Fig. 13, illustrates a process used in a method according to an embodiment of the invention for producing a thin-film multilayer device 100. Fig. 14 (A) is a cross-sectional view taken along line A-A, and Fig. 14 (B) is a plan view with some details omitted.
[Fig. 15] Fig. 15, a continuation of Fig. 14, illustrates a process used in a method according to an embodiment of the invention for producing a thin-film multilayer device 100. Fig. 15 (A) is a cross-sectional view taken along line A-A, and Fig. 15 (B) is a plan view with some details omitted.
[Fig. 16] Fig. 16, a continuation of Fig. 15, illustrates a process used in a method according to an embodiment of the invention for producing a thin-film multilayer device 100. Fig. 16 (A) is a cross-sectional view taken along line A-A, and Fig. 16 (B) is a plan view with some details omitted.
[Fig. 17] Fig. 17, a continuation of Fig. 16, illustrates a process used in a method according to an embodiment of the invention for producing a thin-film multilayer device 100. Fig. 17 (A) is a cross-sectional view taken along line A-A, and Fig. 17 (B) is a plan view with some details omitted.
[Fig. 18] Fig. 18, a continuation of Fig. 17, illustrates a process used in a method according to an embodiment of the invention for producing a thin-film multilayer device 100. Fig. 18 (A) is a cross-sectional view taken along line A-A, and Fig. 18 (B) is a plan view with some details omitted.
[Fig. 19] Fig. 19, a continuation of Fig. 18, illustrates a process used in a method according to an embodiment of the invention for producing a thin-film multilayer device 100. Fig. 19 (A) is a cross-sectional view taken along line A-A, and Fig. 19 (B) is a plan view with some details omitted.
[Fig. 20] Fig. 20, a continuation of Fig. 19, illustrates a process used in a method according to an embodiment of the invention for producing a thin-film multilayer device 100. Fig. 20 (A) is a cross-sectional view taken along line A-A, and Fig. 20 (B) is a plan view with some details omitted.
[Fig. 21] Fig. 21, a continuation of Fig. 20, illustrates a process used in a method according to an embodiment of the invention for producing a thin-film multilayer device 100. Fig. 21 (A) is a cross-sectional view taken along line A-A, and Fig. 21 (B) is a plan view with some details omitted. Fig. 21 is also an illustration of the finished structure of the thin-film multilayer device 100 according to an embodiment of the invention.
[Fig. 22] Fig. 22 illustrates a known method for producing a thin-film multilayer device. Fig. 22 (A) is a cross-sectional view of a thin-film multilayer body 107, and Fig. 22 (B) is a plan view of alignment marks 131 formed on the uppermost layer of the thin-film multilayer body 107. Description of Embodiments

The following describes an embodiment of the present invention with reference to drawings.

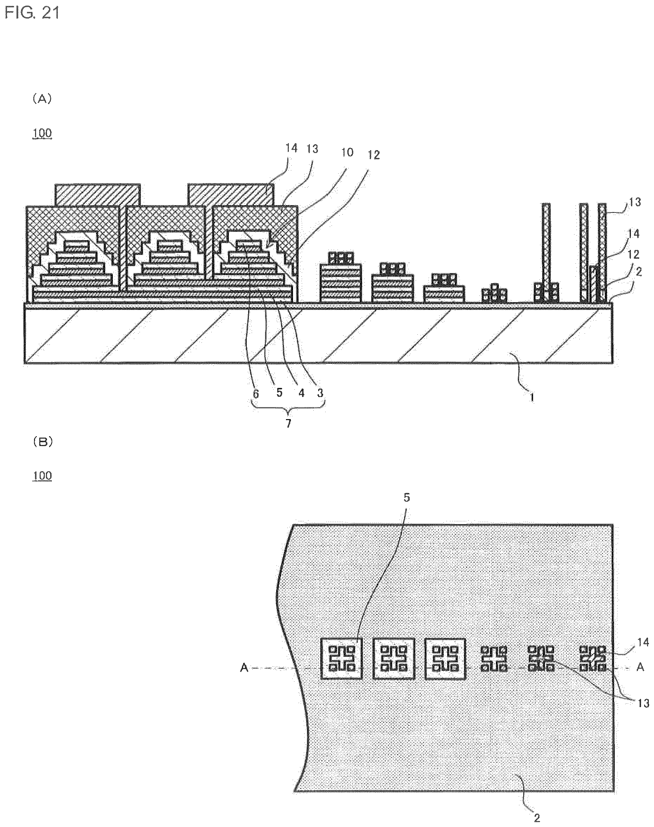

Fig. 21 illustrates a thin-film multilayer device 100 that functions as a thin-film capacitor, providing an example of a thin-film multilayer device produced using a method according to this embodiment for producing a thin-film multilayer device.

The thin-film multilayer device 100 has a substrate 1 made of Si, the substrate having a Si thermal oxide film 2 made of SiO₂ on its surface.

On the thermal oxide film 2, a dielectric thin film 3 is disposed that functions as an adhesion layer and is made of (Ba, Sr)TiO₃ (hereinafter referred to as BST). On the dielectric film 3, a conductive thin film 4 is disposed that functions as a capacitor electrode and is made of Pt. On the conductive thin film 4, a dielectric thin film 5 is disposed that functions as a capacitor dielectric and is made of BST. On the dielectric thin film 5, as many pairs of a conductive thin film 4 and a dielectric thin film 5 as needed are disposed. On the uppermost conductive thin film 4, a dielectric thin film 6 is disposed that functions as a protective layer and is made of BST. These thin films, i.e., a dielectric thin film 3, multiple conductive thin films 4, multiple dielectric thin films 5, and a dielectric thin film 6, make up a thin-film multilayer body 7.

The thin-film multilayer body 7 has a device section 10 that functions as a thin-film capacitor.

An inorganic protective film 12 made of SiO₂ for enhancing moisture resistance and an organic protective film 13 for buffering external forces are disposed around the device section 10.

An outer electrode 14 is disposed on the organic protective film 13 so as to be connected to a predetermined point on the conductive thin films 4 as capacitor electrodes. The outer electrode 14 is made up of a Ti thin film, a Ni thin film, and a Au thin film stacked in this order (not illustrated).

The following describes a method according to an embodiment of the present invention for producing the thin-film multilayer device 100.

### (First process)

In a first process, a thin-film multilayer body 7 is formed on a substrate 1 having a thermal oxide film 2 on its surface.

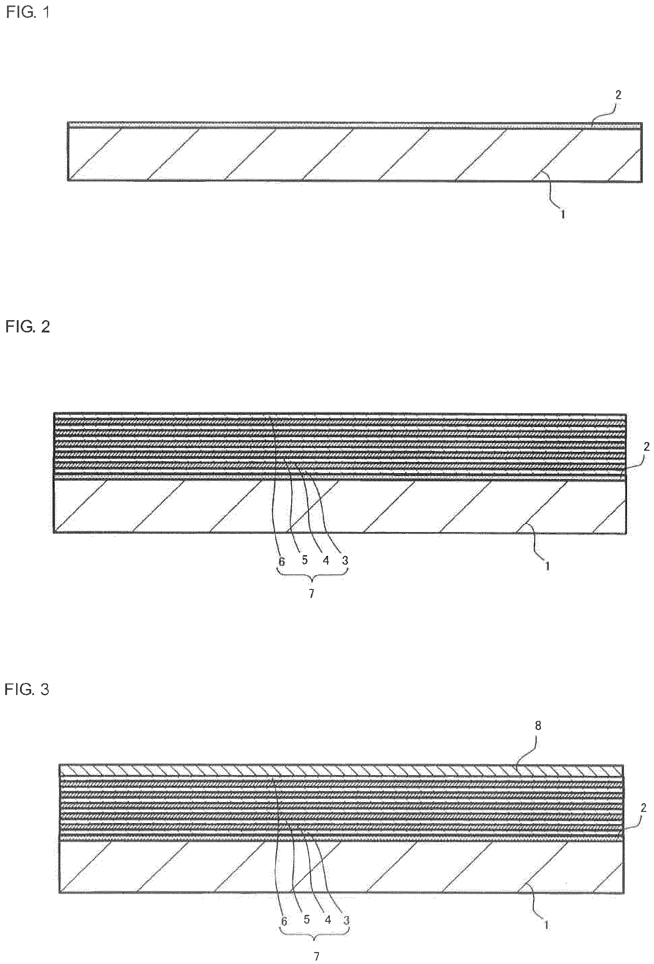

First, as illustrated in Fig. 1, a substrate 1 is provided that is made of Si and has a Si thermal oxide film 2 made of SiO₂ on its surface. The thickness of the thermal oxide film 2 is, for example, 700 nm, and the thickness of the substrate 1 is, for example, 0.5 mm.

Then as illustrated in Fig. 2, a dielectric thin film 3 made of BST is formed on the thermal oxide film 2 using metal organic deposition (MOD). The thickness of the dielectric thin film 3 is, for example, 100 nm. On this dielectric thin film 3, a conductive thin film 4 made of Pt is formed using sputtering. The thickness of the conductive thin film 4 is, for example, 200 nm. On this conductive film 4, a step of alternately forming a dielectric thin film 5 made of BST and a conductive thin film 4 made of Pt in the way described above is performed four times. Lastly, a dielectric thin film 6 made of BST is formed.

Through these steps, a thin-film multilayer body 7 made up of a dielectric thin film 3, multiple conductive thin films 4, multiple dielectric thin films 5, and a dielectric thin film 6 is formed on a substrate 1 having a thermal oxide film 2 on its surface.

### (Second process)

In a second process, an alignment mark 31a to be used in a third process, which follows this second process, is formed on the surface of the thin-film multilayer body 7.

First, as illustrated in Fig. 3, a positive photosensitive resist 8 is applied to the dielectric thin film 6 using spin coating and then baked.

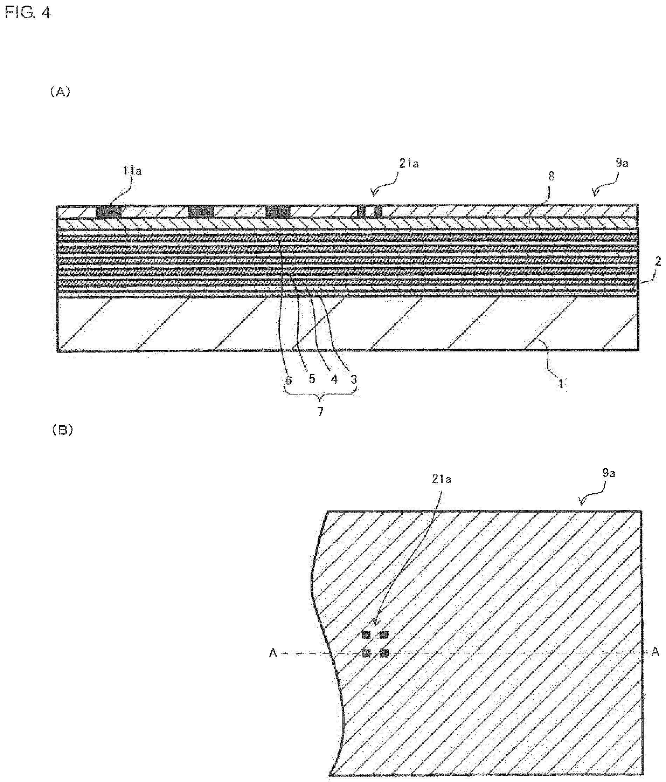

Then as illustrated in Figs. 4 (A) and (B), a photomask 9a having a device-section pattern 11a and an alignment pattern 21a is placed on the photosensitive resist 8. The alignment pattern 21a is made up of four square elements arranged at certain intervals.

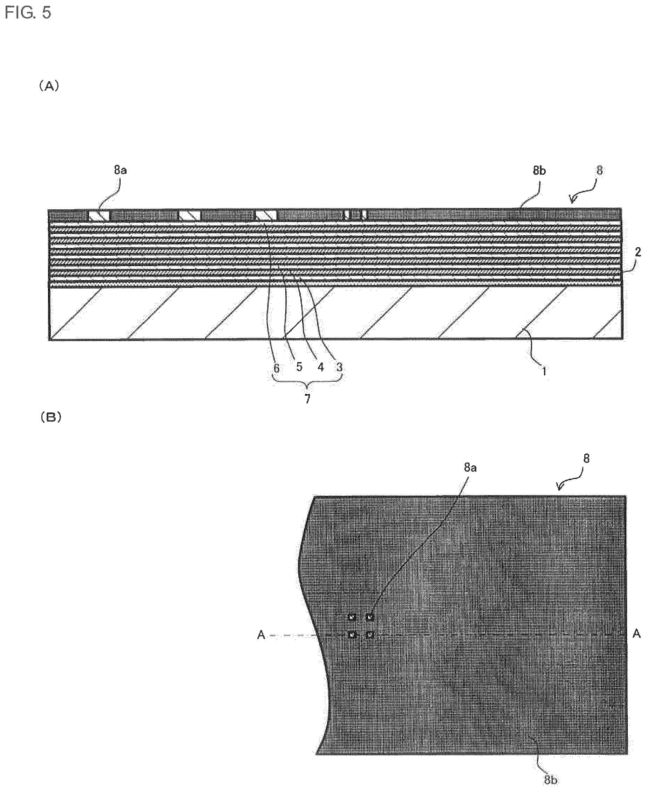

The photosensitive resist 8 is exposed through the photomask 9a, and then the photomask 9a is removed. As a result, the photosensitive resist 8 has an unexposed portion 8a and an exposed portion 8b as illustrated in Figs. 5 (A) and (B).

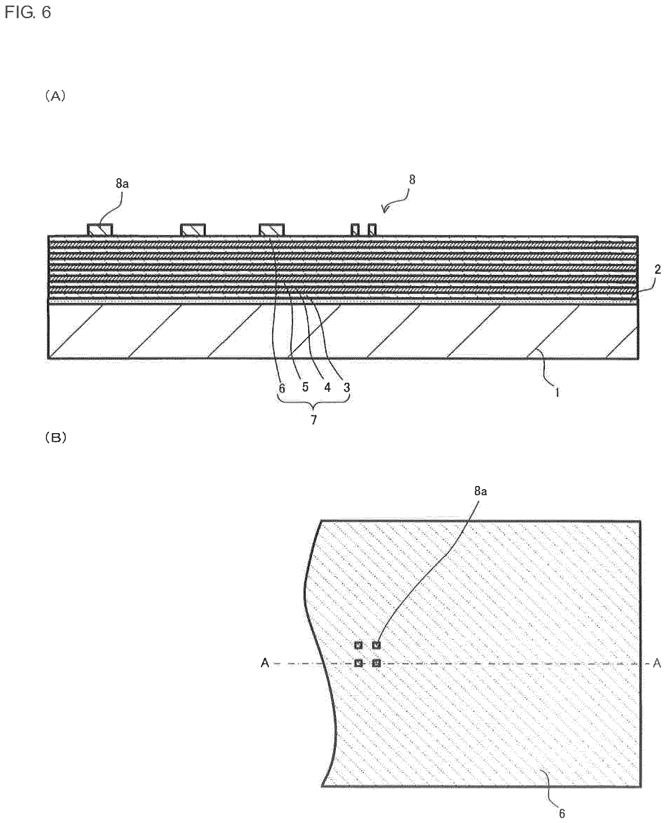

Then as illustrated in Figs. 6 (A) and (B), the unexposed portion 8b of the photosensitive resist 8 is removed through development, forming a patterned photosensitive resist 8 on the thin-film multilayer body 7.

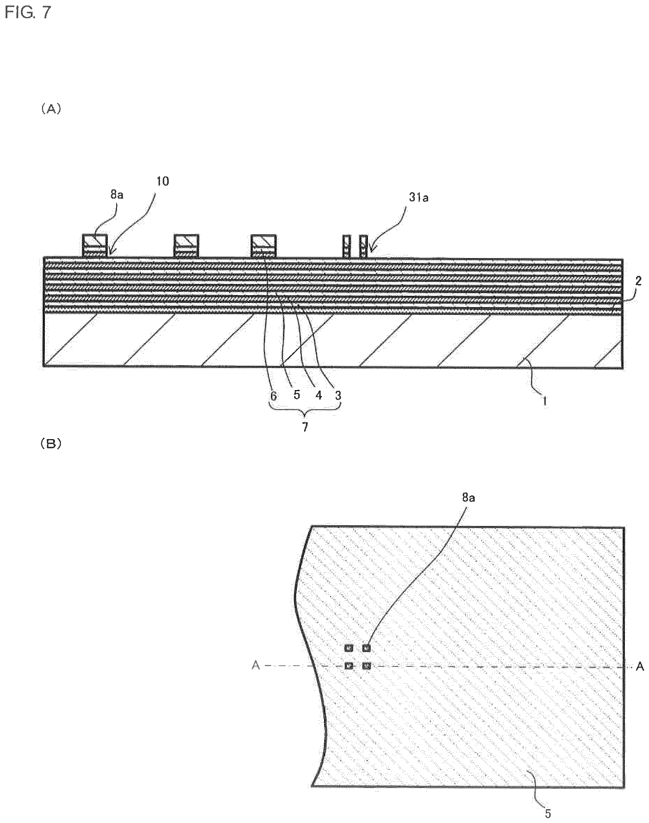

Then as illustrated in Figs. 7 (A) and (B), the dielectric thin film 6 coated with the photosensitive resist 8 and a conductive thin film 4 are processed together using RIE (reactive ion etching), forming a device section 10 and creating an alignment mark 31a on a portion of the surface of the thin-film multilayer body 7.

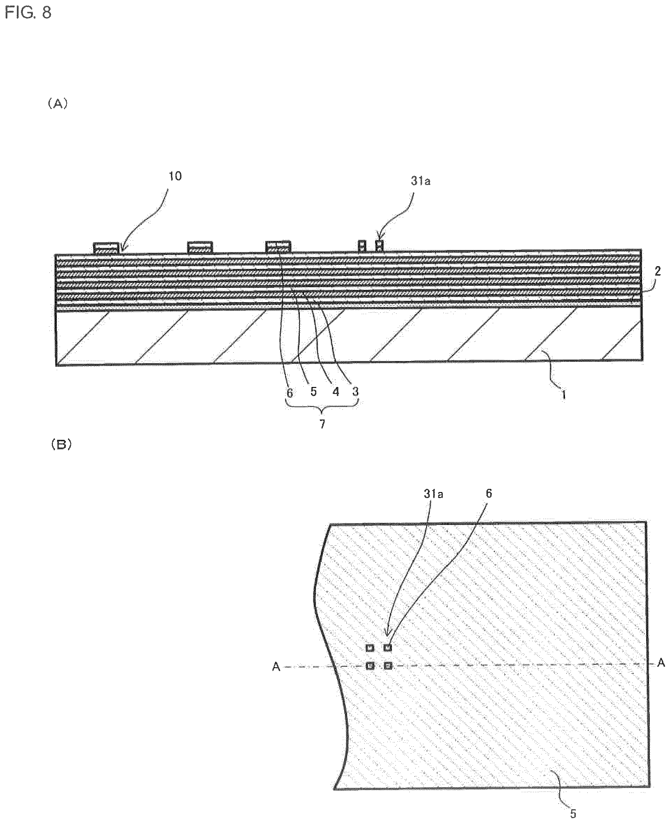

Then as illustrated in Figs. 8 (A) and (B), the photosensitive resist 8 is removed from the thin-film multilayer body 7 using O₂ plasma ashing.

Through these steps, an alignment mark 31a to be used in the next process and a device section 10 are completed on a portion of the surface of the thin-film multilayer body 7.

### (Third process)

In a third process, etching is performed through a photomask positioned using the alignment mark 31a formed in the second process. Through this, the thin-film multilayer body 7 is processed from its surface, further forming the device section 10 and creating a new alignment mark.

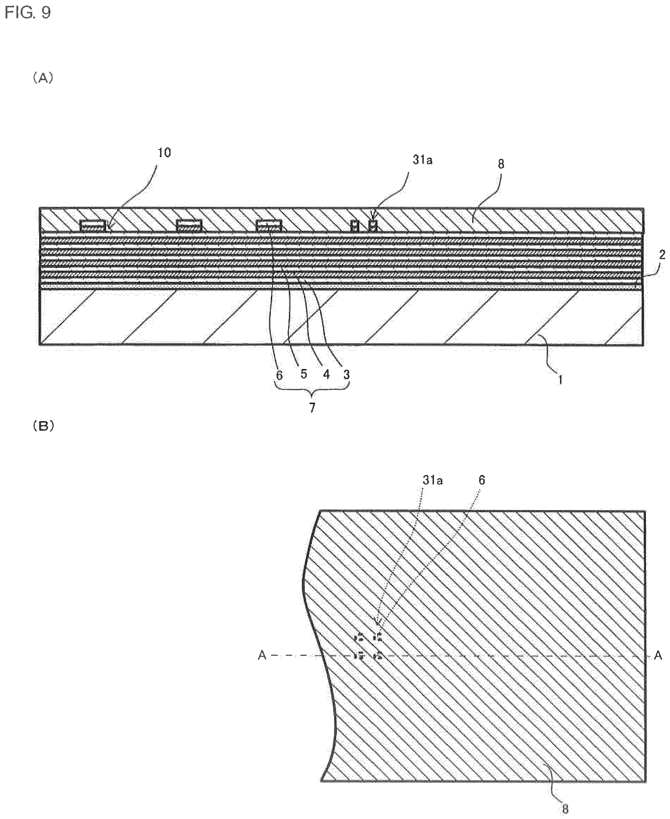

First, as illustrated in Figs. 9 (A) and (B), a positive photosensitive resist 8 is applied to the surface of the thin-film multilayer body 7 using spin coating and then baked.

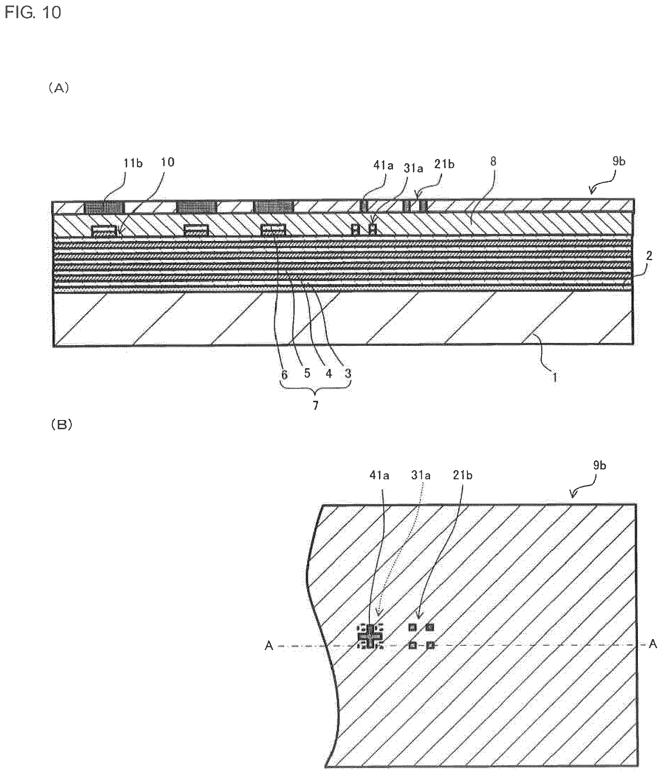

Then as illustrated in Figs. 10 (A) and (B), a photomask 9b having a device-section pattern 11b, an alignment pattern 21b, and a cruciform alignment pattern 41a is placed on the photosensitive resist 8.

More specifically, the photomask 9b is placed in position on the photosensitive resist 8 through the alignment of the cruciform alignment pattern 41a with the alignment mark 31a, which is formed on the surface of the thin-film multilayer body 7 in the previous process.

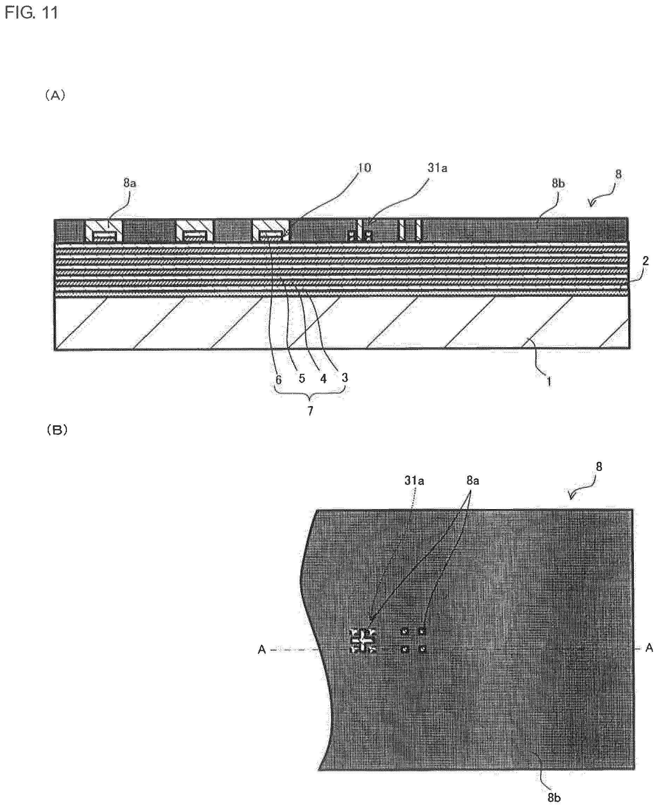

Then the photosensitive resist 8 is exposed through the photomask 9b, and the photomask 9b is removed. As a result, the photosensitive resist 8 has an unexposed portion 8a and an exposed portion 8b as illustrated in Figs. 11 (A) and (B).

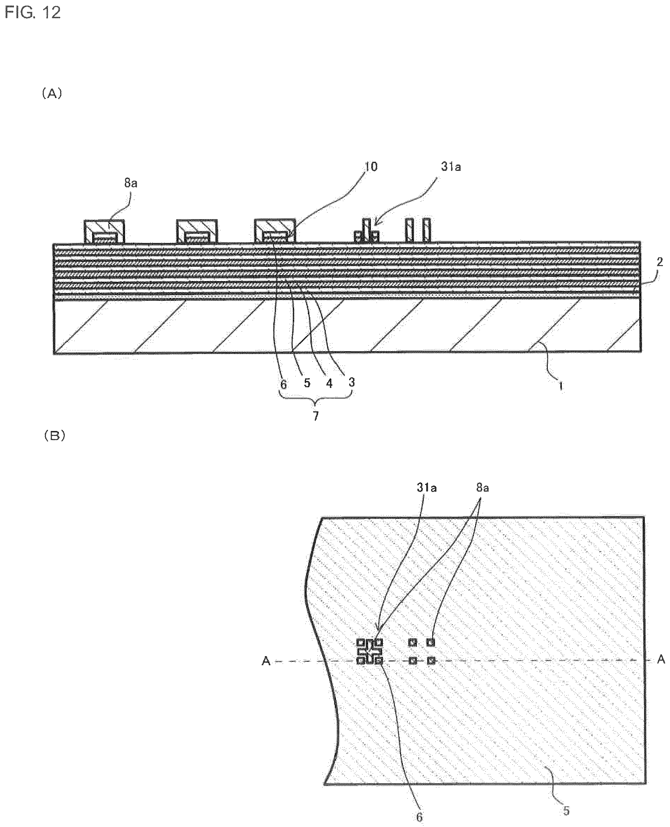

Then as illustrated in Figs. 12 (A) and (B), the unexposed portion 8b of the photosensitive resist 8 is removed through development, forming a patterned photosensitive resist 8 on the thin-film multilayer body 7.

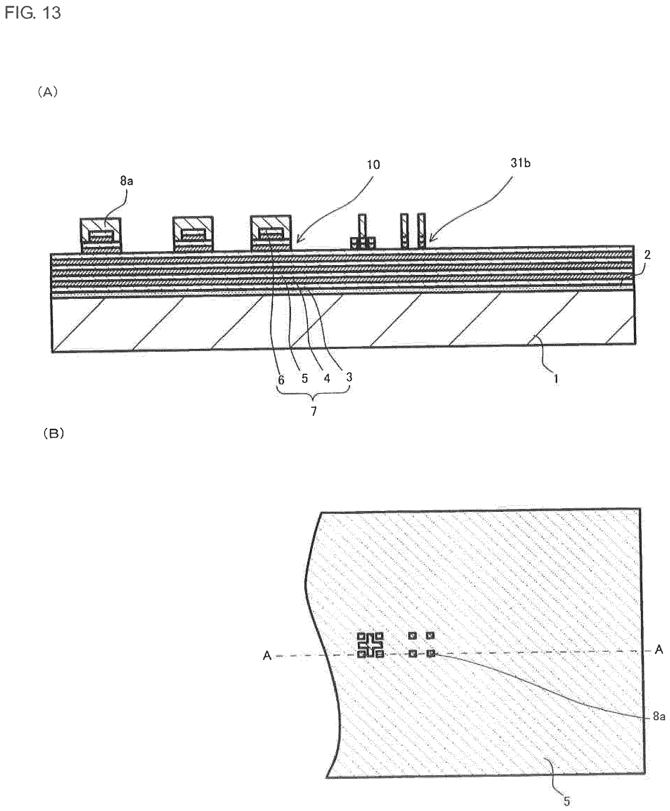

Then as illustrated in Figs. 13 (A) and (B), the dielectric thin film 6 coated with the photosensitive resist and a conductive thin film 4 are processed together using RIE, further forming the device section 10 and creating a new alignment mark 31b on the thin-film multilayer body 7.

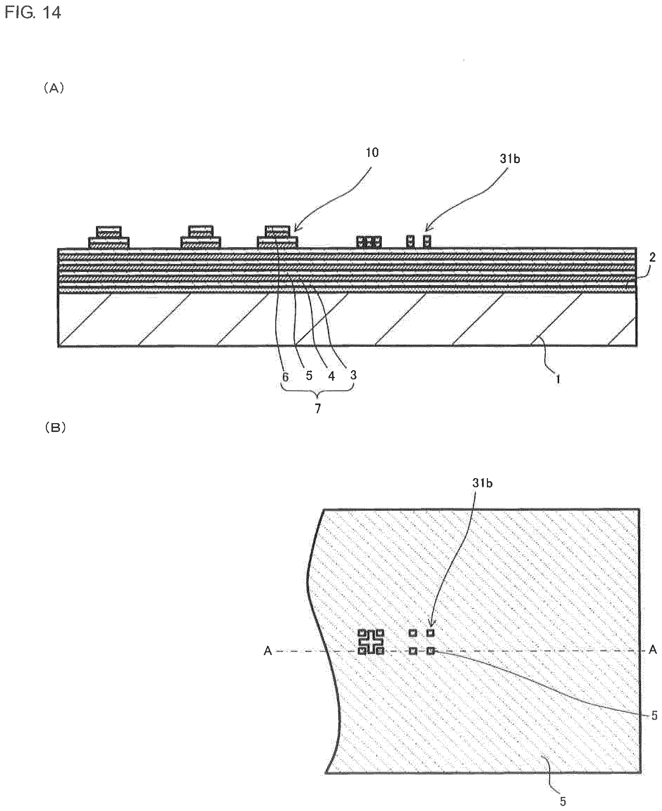

Then as illustrated in Figs. 14 (A) and (B), the photosensitive resist 8 is removed from the thin-film multilayer body 7 using O₂ plasma ashing.

### (Second and subsequent third processes)

In second and subsequent third processes, the above third process is repeated multiple times to process the thin-film multilayer body 7 sequentially from its surface, thereby further forming the device section 10. In each of the repeated third processes, a photomask is positioned using an alignment mark formed in the previous third process.

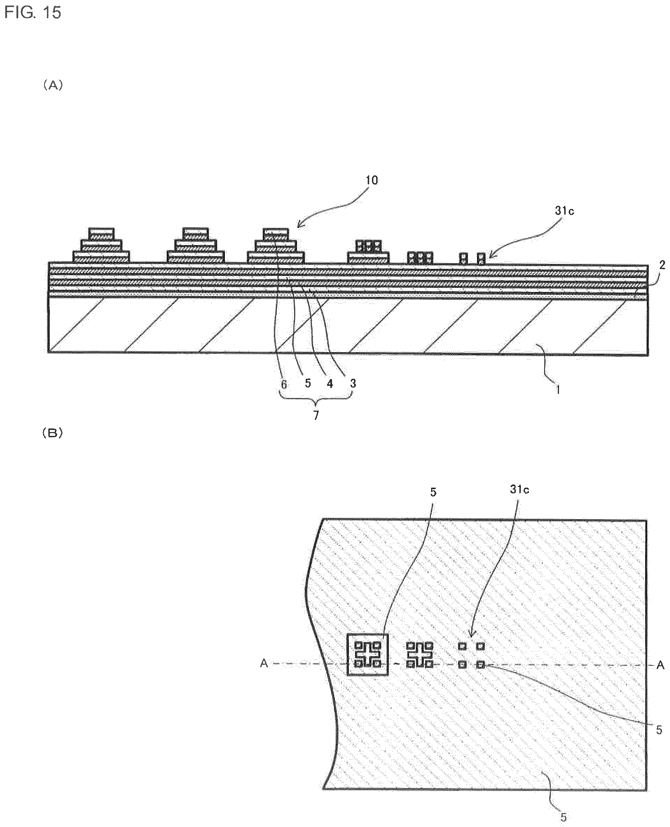

First, the above third process is repeated using the new alignment mark 31b to position a photomask (not illustrated), further forming the device section 10 and creating an alignment mark 31c to be used in the next process on the thin-film multilayer body 7 as illustrated in Figs. 15 (A) and (B).

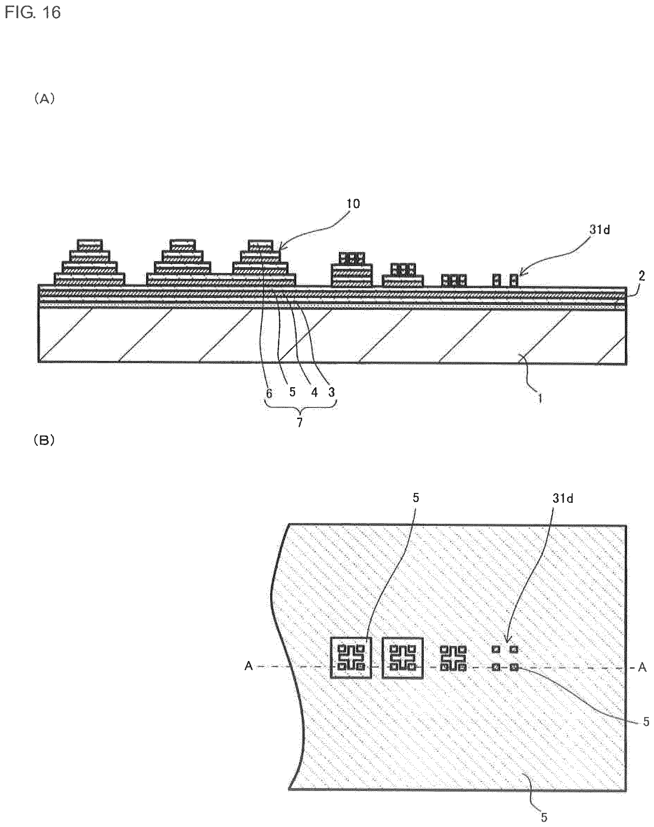

Then the above third process is repeated using the new alignment mark 31c to position a photomask (not illustrated), further forming the device section 10 and creating an alignment mark 31d to be used in the next process on the thin-film multilayer body 7 as illustrated in Figs. 16 (A) and (B).

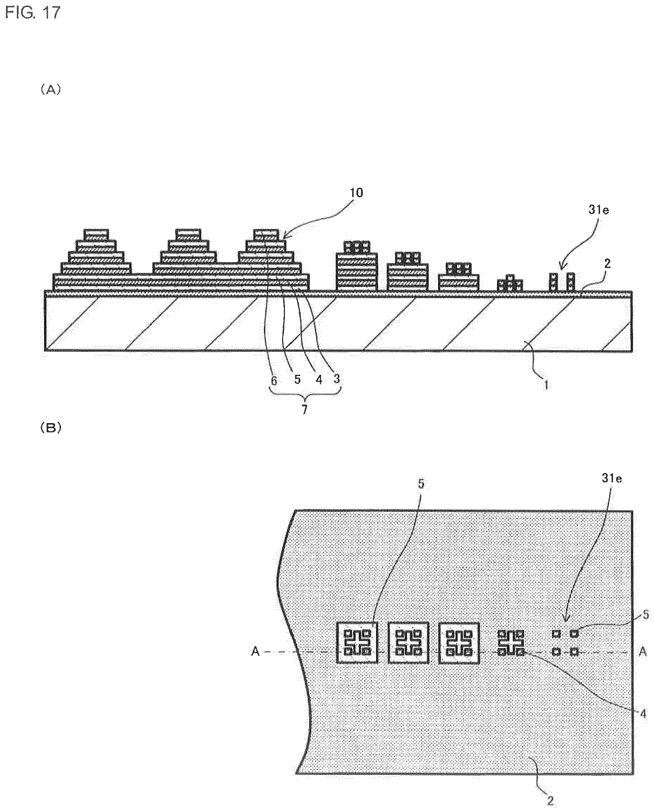

Then the above third process is repeated using the new alignment mark 31d to position a photomask (not illustrated), further forming the device section 10 and creating an alignment mark 31e to be used in the next process on the thin-film multilayer body 7 as illustrated in Figs. 17 (A) and (B).

In this way, during the processing of the thin-film multilayer body 7, photomasks are positioned using an alignment mark formed in the previous process. This means that the photosensitive resist 8 is applied to and detached from the surface of the alignment mark only once before alignment, reducing damage to the alignment mark. Alignment using a less damaged alignment mark ensures a small misalignment between the correct position of the alignment mark and the recognized one, thereby helping to maintain the accuracy in the processing of the device section 10.

### (Fourth process)

In a fourth process, the thin-film multilayer device 100 is completed through the formation of an inorganic protective film 12 made of SiO₂ and an organic protective film 13, which both surround the device section 10, and an outer electrode 14 connected to a portion of the conductive thin films 4 as capacitor electrodes.

First, the entire thin-film multilayer body 7 including the device section 10 is subjected to a heat treatment at approximately 850°C.

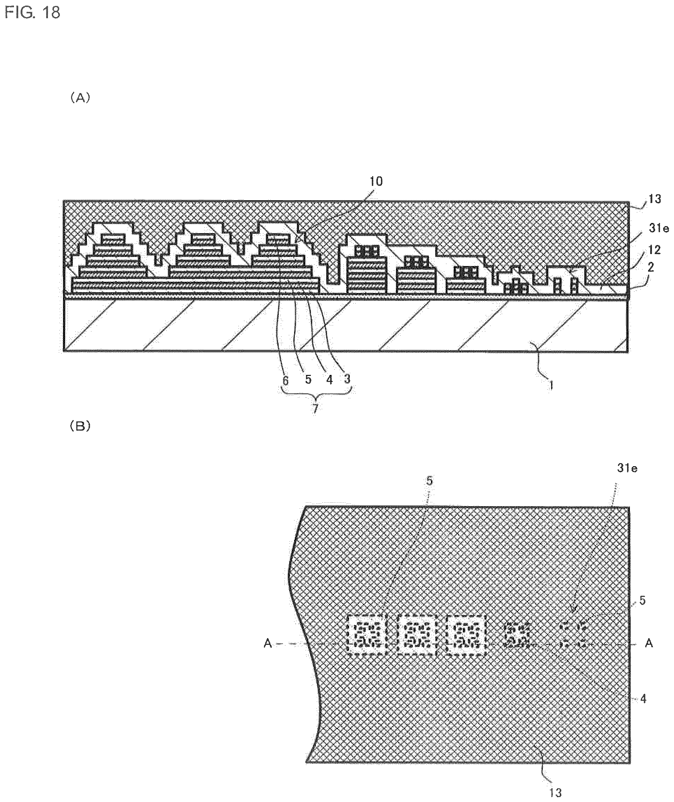

Then as illustrated in Figs. 18 (A) and (B), an inorganic protective film 12 made of SiO₂ is formed using chemical vapor deposition (CVD). Then an organic protective film 13 that functions as a positive photosensitive resist is applied using spin coating. The thickness of the inorganic protective film 12 is, for example, 700 nm, and the thickness of the organic protective film 13 is, for example, 5000 nm.

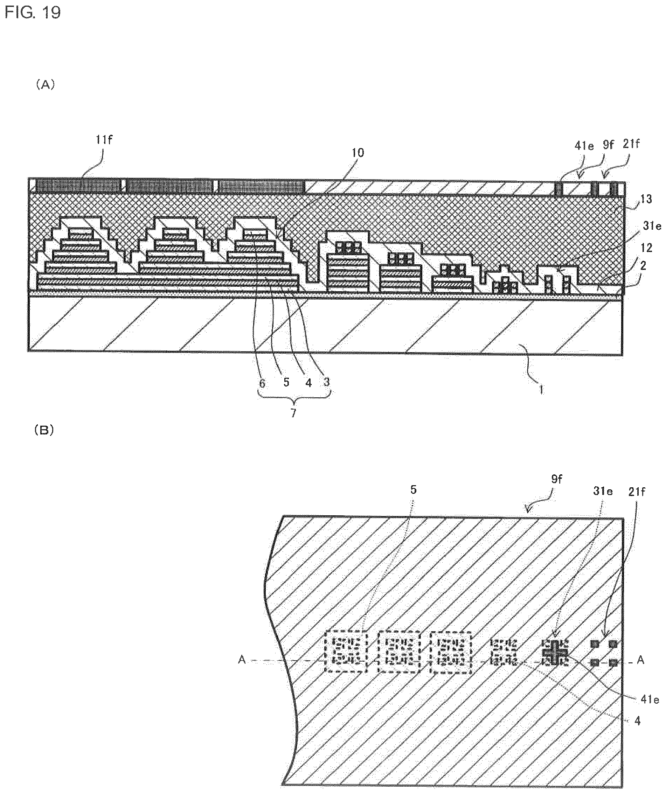

Then as illustrated in Figs. 19 (A) and (B), a photomask 9f having an alignment pattern 21f is placed in position on the organic protective film 13 through, as in the second process, the alignment of a cruciform alignment pattern 41e created in the photomask 9f with the alignment mark 31e formed in the previous process.

Then the positive organic protective film 13 is exposed through the photomask 9f having the alignment pattern 21f and then developed to pattern the organic protective film 13.

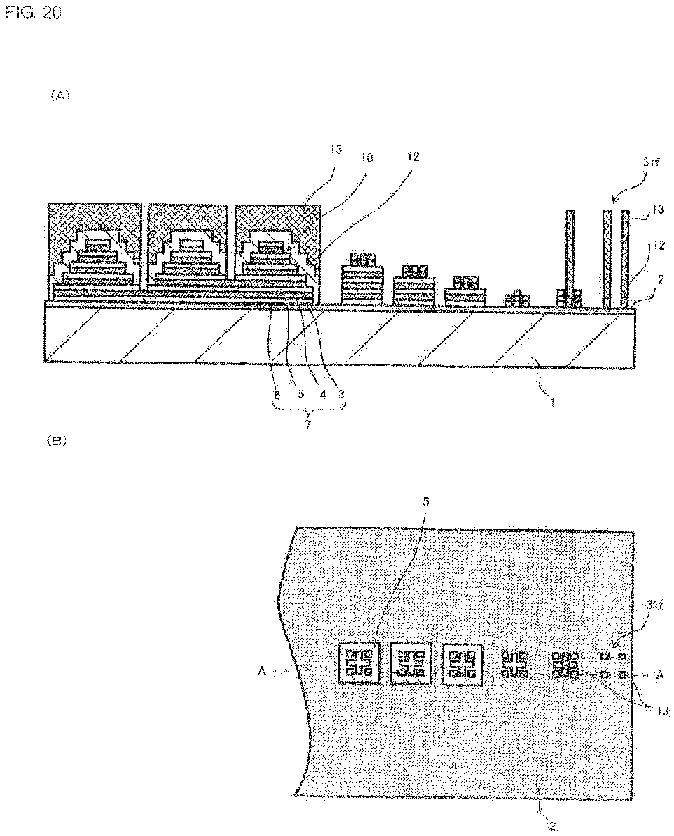

Then as illustrated in Figs. 20 (A) and (B), the inorganic protective film 12 and the dielectric thin films 5 are together dry-etched with CHF₃ gas using the patterned organic protective film 13 as a mask to exposed a portion of the conductive thin films 4 as capacitor electrodes. Through this dry-etching of the inorganic protective film 12, a new alignment mark 31f is also created.

Lastly, as illustrated in Figs. 21 (A) and (B), an outer electrode 14 is formed so as to be connected to a portion of the conducive thin films 4 as capacitor electrodes of the device section 10 through sputtering using the alignment mark 31f, completing the thin-film multilayer device 100.

More specifically, a Ti thin film, a Ni thin film, and a Au thin film are sequentially formed using sputtering. The thickness of the Ti thin film is, for example, 50 nm, the thickness of the Ni thin film is, for example, 1000 nm, and the thickness of the Au thin film is, for example, 200 nm.

Then a positive photosensitive resist (not illustrated) is applied using spin coating.

Then an alignment pattern created in a photomask (not illustrated) is aligned with the alignment mark 31f, and this photomask is used to form a pattern corresponding to the outer electrode 14 in the photosensitive resist. Then the layer made up of the Ti thin film, the Ni thin film, and the Au thin film and masked with the photosensitive resist is processed using RIE, forming an outer electrode 14 connected to a portion of the conductive thin films 4 as capacitor electrodes.

Lastly, the photosensitive resist 8 is removed using O₂ plasma ashing to complete a patterned outer electrode 14.

Methods according to an embodiment of the present invention for producing a thin-film multilayer device are not limited to the above, and various modifications can be made without departing from the gist of the invention. For example, the third process, which is repeated multiple times in the production method according to the above embodiment, may be performed once. The photosensitive resists, which are positive ones in the above embodiment, may be negative ones. The number of layers etched together in each round of etching, which is one conductive thin film and one dielectric thin film in the above embodiment, is not limited. Furthermore, the alignment marks created in the thin-film multilayer body and the alignment pattern of the photomasks may have any shape that allows for accurate alignment for etching.

### Reference Signs List

- 1: Substrate
- 2: Thermal oxide film
- 3, 5, 6: Dielectric thin films
- 4: Conductive thin film
- 7: Thin-film multilayer body
- 8: Photosensitive resist
- 8a: Unexposed portion
- 8b: Exposed portion
- 9a,: 9b, 9f Photomasks
- 10: Device section
- 11a, 11b, 11f: Device-section patterns
- 12: Inorganic protective film
- 13: Organic protective film
- 14: Outer electrode
- 21a, 21b, 21f, 41a, 41e: Alignment patterns
- 31a to 31f: Alignment marks
- 100: Thin-film multilayer device

## Claims

1. A method for producing a thin-film multilayer device, the method comprising
a first process having a step of forming a thin-film multilayer body having a plurality of thin films,
a second process having a step of applying a photosensitive resist to the thin-film multilayer body,
a step of exposing the resist through a photomask and developing the exposed resist,
a step of etching the thin-film multilayer body coated with the developed photosensitive resist to form a device section and an alignment mark on the thin-film multilayer body, and
a step of removing the photosensitive resist from the etched thin-film multilayer body, and
a third process having a step of applying a photosensitive resist to the thin-film multilayer body,
a step of placing a photomask having an alignment pattern in position on the photosensitive resist by aligning the alignment pattern with the alignment mark formed in the previous process,
a step of exposing the photosensitive resist through the photomask and developing the exposed photosensitive resist,
a step of etching the thin-film multilayer body coated with the developed photosensitive resist to form a device section and an alignment mark on the thin-film multilayer body, and
a step of removing the photosensitive resist from the etched thin-film multilayer body.

2. The method according to Claim 1 for producing a thin-film multilayer device, wherein the third process is repeated twice or more.

3. The method according to Claim 1 or 2 for producing a thin-film multilayer device, wherein the alignment mark formed in a third process is created in a lower layer of the thin-film multilayer body than the alignment mark formed in the previous third process.

4. The method according to any one of Claims 1 to 3 for producing a thin-film multilayer device, wherein the thin-film multilayer body includes an alternate stack of a conductive thin film and a dielectric thin film, and
in the second process or the third process, the conductive thin film and the dielectric thin film are etched together.

## Patentansprüche

1. Ein Verfahren zum Herstellen eines Dünnfilm-Mehrschicht-Bauelements, wobei das Verfahren Folgendes aufweist:
einen ersten Vorgang mit einem Schritt eines Bildens eines Dünnfilm-Mehrschicht-Körpers mit einer Mehrzahl von Dünnfilmen,
einen zweiten Vorgang mit einem Schritt eines Aufbringens eines photoempfindlichen Resists auf den Dünnfilm-Mehrschicht-Körper,
einen Schritt eines Freilegens des Resists durch eine Photomaske und eines Entwickelns des freiliegenden Resists,
einen Schritt eines Ätzens des Dünnfilm-Mehrschicht-Körpers, der mit dem entwickelten photoempfindlichen Resist beschichtet ist, um ein Bauelementsegment und eine Ausrichtungsmarke auf dem Dünnfilm-Mehrschicht-Körper zu bilden, und
einen Schritt eines Entfernens des photoempfindlichen Resists von dem geätzten Dünnfilm-Mehrschicht-Körper und
einen dritten Vorgang mit einem Schritt eines Aufbringens eines photoempfindlichen Resists auf den Dünnfilm-Mehrschicht-Körper,
einen Schritt eines Inpositionbringens einer Photomaske mit einer Ausrichtungsstruktur auf dem photoempfindlichen Resist durch Ausrichten der Ausrichtungsstruktur mit der Ausrichtungsmarke, die bei dem vorherigen Vorgang gebildet wurde,
einen Schritt eines Freilegens des photoempfindlichen Resists durch die Photomaske und eines Entwickelns des freiliegenden photoempfindlichen Resists,
einen Schritt eines Ätzens des Dünnfilm-Mehrschicht-Körpers, der mit dem entwickelten photoempfindlichen Resist beschichtet ist, um ein Bauelementsegment und eine Ausrichtungsmarke auf dem Dünnfilm-Mehrschicht-Körper zu bilden, und
einen Schritt eines Entfernens des photoempfindlichen Resists von dem geätzten Dünnfilm-Mehrschicht-Körper.

2. Das Verfahren gemäß Anspruch 1 zum Herstellen eines Dünnfilm-Mehrschicht-Bauelements, bei dem der dritte Vorgang zweimal oder häufiger wiederholt wird.

3. Das Verfahren gemäß Anspruch 1 oder 2 zum Herstellen eines Dünnfilm-Mehrschicht-Bauelements, bei dem die Ausrichtungsmarke, die bei einem dritten Vorgang gebildet wird, in einer Schicht des Dünnfilm-Mehrschicht-Körpers erzeugt wird, die sich weiter unten befindet als die Ausrichtungsmarke, die bei dem vorherigen dritten Vorgang gebildet wird.

4. Das Verfahren gemäß einem der Ansprüche 1 bis 3 zum Herstellen eines Dünnfilm-Mehrschicht-Bauelements, bei dem der Dünnfilm-Mehrschicht-Körper einen alternierenden Stapel eines leitfähigen Dünnfilms und eines dielektrischen Dünnfilms umfasst, und
der leitfähige Dünnfilm und der dielektrische Dünnfilm bei dem zweiten Vorgang oder dem dritten Vorgang zusammen geätzt werden.

## Revendications

1. Procédé de fabrication d'un dispositif multicouches à films minces, le procédé comprenant :
un premier processus ayant une étape de formation d'un corps multicouches à films minces ayant une pluralité de films minces,
un second processus ayant une étape d'application d'une résine photosensible sur le corps multicouches à films minces,
une étape d'exposition de la résine par le biais d'un masque photographie et de développement de la résine exposée,
une étape de gravure du corps multicouches à films minces recouvert avec la résine photosensible développée afin de former une section de dispositif et une marque d'alignement sur le corps multicouches à films minces, et
une étape de retrait de la résine photosensible du corps multicouches à films minces gravé, et
un troisième processus ayant une étape d'application d'une résine photosensible sur le corps multicouches à films minces,
une étape de placement d'un masque photographique ayant un motif d'alignement en position sur la résine photosensible en alignant le motif d'alignement avec la marque d'alignement formée lors du processus précédent,
une étape d'exposition de la résine photosensible par le biais du masque photographique et de développement de la résine photosensible exposée,
une étape de gravure du corps multicouches à films minces recouvert avec la résine photosensible développée afin de former une section de dispositif et une marque d'alignement sur le corps multicouches à films minces, et
une étape de retrait de la résine photosensible du corps multicouches à films minces gravé.

2. Procédé selon la revendication 1 de fabrication d'un dispositif multicouches à films minces, dans lequel le troisième processus est répété deux fois ou plus.

3. Procédé selon la revendication 1 ou 2 de fabrication d'un dispositif multicouches à films minces, dans lequel la marque d'alignement formée lors d'un troisième processus est créée dans une couche du corps multicouches à films minces plus basse que la marque d'alignement formée lors du troisième processus précédent.

4. Procédé selon l'une quelconque des revendications 1 à 3 de fabrication d'un dispositif multicouches à films minces, dans lequel le corps multicouches à films minces comprend une pile alternée de film mince conducteur et de film mince diélectrique, et lors du second processus ou du troisième processus, le film mince conducteur et le film mince diélectrique sont gravés ensemble.
